# EUROPEAN PATENT APPLICATION

(11) **EP 4 428 923 A1**
(43) Date of publication of application: **11.09.2024**
(21) Application number: 23160685.6
(22) Date of filing: 08.03.2023
(51) Int. Cl.: H01L 29/06, H01L 29/08, H01L 29/10, H01L 29/66, H01L 29/737

(54) **A SIGE HBT AND METHODS OF MANUFACTURING THE SAME**

(71) Applicant: NXP B.V., 5656 AG Eindhoven (NL)
(72) Inventor: Donkers, Johannes Josephus Theodorus Marinus, 5656AG Eindhoven (NL); John, Jay Paul, 5656AG Eindhoven (NL); Kirchgessner, James Albert, 5656AG Eindhoven (NL); Sebel, Patrick, 5656AG Eindhoven (NL)
(74) Representative: Hardingham, Christopher Mark

(57) **Abstract**

Disclosed is a SiGe heterojunction bipolar transistor, HBT, and method of manufacturing the same, comprising: an n-doped buried collector (HV); a p-doped epitaxial monocrystalline SiGe base layer, within a layer stack, the layer stack (110) being over and in direct contact with the collector (HV); an n-doped monocrystalline silicon emitter (142) over a first area of the layer stack (110), the emitter provided with a polycrystalline silicon emitter contact layer (144) thereon; an epitaxial silicon base contact layer (218) over a second area of the layer stack (110); an oxide layer (216) over a third area of the layer stack between the first and second areas, wherein the oxide layer (216) and the n-doped monocrystalline silicon emitter (142) are within a window in the epitaxial silicon base contact layer (218), the window having sidewalls; dielectric spacers (132) on the sidewalls of the window and over the oxide layer (216), and providing electrical isolation between the epitaxial silicon layer (218) and the polycrystalline silicon layer (144); the epitaxial silicon layer (218) extending beneath the dielectric spacers (132) on the sidewalls of the window and extending upward (218d) between the dielectric spacers (132) and a further dielectric layer (120).

## Description

### Field

The present disclosure relates to SiGe heterojunction bipolar transistors (HBT) and methods of manufacture of the same.

### Background

In order to provide electrical connection between the outside world (or other parts of an integrated device) and the intrinsic base region of a SiGe heterojunction bipolar transistor, conventionally a conductive path is provided by means of a combination of layers, one of which is in direct contact with the SiGe intrinsic base layer of the HBT. In particular, the combination of layers may include a silicon overlayer deposited or grown over the SiGe intrinsic base layer as part of the layer stack, and a so-called "polysilicon base layer". For high-performance devices it is desirable that the resistance of the conductive path be relatively low.

### Summary

According to one aspect of the present disclosure, there is provided a method of manufacturing a SiGe Heterojunction junction transistor device, the method comprising a sequence of steps including: prior (2010) processing steps; depositing (2020) a layer stack comprising SiGe (110), and a first oxide layer (216), on at least a device region; depositing (2022) at least a sacrificial layer (318) over the device region; depositing (2024) a first dielectric layer(120) over the sacrificial layer; patterning (2026) a photoresist layer and etching a window (140) in the first dielectric layer (120) and the sacrificial layer (318) through an opening in the photoresist layer; depositing (2028) a dielectric spacer comprising an oxide layer (130) and a nitride layer (132) on sidewalls of the window and on a part of a bottom of the window; depositing (2030) a monocrystalline silicon emitter layer (142) in the bottom of the window and a polycrystalline silicon emitter contact layer (144) over the dielectric spacer and the silicon emitter layer; depositing (2034) a protective dielectric layer (646, 848) over the silicon emitter layer, thereby filling the window, and surrounding the silicon emitter contact layer; removing (2036) the sacrificial layer (318); removing (2038) the first oxide layer (216); epitaxially growing (2040) a silicon layer (218); removing (2042) the protective dielectric layer; and subsequent (2044) processing steps. By using a sacrificial layer instead of the conventional base contact layer, and replacing the sacrificial layer by a later grown epitaxial silicon (218) layer to act as a base contact layer, it may be possible to reduce the resistance of the base contact layer and the overall electrical conductive path to the intrinsic base of the HBT, relative to the use conventional base contact layers.

According to one or more embodiments, the sacrificial layer is a polysilicon layer (318).

According to one or more embodiments the dielectric layer over the sacrificial layer comprises a nitride layer (120).

According to one or more other embodiments the sacrificial layer is a nitride layer (1418), and the dielectric layer over the sacrificial layer is an oxide layer (1420).

According to one or more embodiments the protective dielectric layer is an oxide layer (646, 848).

According to one or more embodiments the protective dielectric layer is deposited in two stages, with a pattered etch therebetween and an un-patterned etch thereafter, wherein the first stage provides oxide (646) to protect the window and top of the silicon emitter contact layer, and the second stage provides oxide (848) to protect outer sidewalls of the silicon emitter contact layer and sidewalls of the first dielectric layer (120). By using two stages, protection can be provided for both the top, and exposed side edges, of the silicon emitter contact layer.

According to one or more other embodiments, the protective dielectric layer is a nitride layer (1548). In one or more such embodiments the protective dielectric layer deposited by plasma-enhanced chemical vapour deposition (PECVD).

According to one or more embodiments the first dielectric layer is a LPCVD Nitride layer.

According to one or more embodiments the step of depositing a dielectric spacer comprising an oxide layer and a nitride layer on sidewalls of the window and on a part of a bottom of the window comprises deposition of a stack of layers including an oxide-nitride-oxide, ONO, stack and subsequently etching an exposed oxide layer.

According to a second aspect of the present disclosure, there is provided a SiGe Heterojunction Bipolar Transistor, HBT, (200) comprising an emitter, a base and a collector, wherein: the collector comprises an n-doped implanted region (160); the base comprises a p-doped SiGe layer, within a layer stack (110) comprising at least the p-doped SiGe layer and having an upper surface (210), the layer stack being over and in direct contact with the collector; the emitter comprises an n-doped monocrystalline silicon emitter (142) over and in direct contact with a first area of the upper surface of the layer stack; wherein the HBT further comprises: an epitaxial silicon layer (218) over and in direct contact with a second area of the upper surface of the layer stack, and for providing an electrical connection to the base; a polycrystalline silicon emitter contact layer (144) for providing an electrical connection to the emitter; an oxide layer (216) over and in direct contact with a third area of the upper surface of the layer stack between the first area and the second area, wherein the oxide layer and the n-doped monocrystalline silicon emitter are within a window in the epitaxial silicon layer, wherein the window has sidewalls; dielectric spacers (132) on the sidewalls of the window and over the oxide layer, and providing electrical isolation between the epitaxial silicon layer and the polycrystalline silicon layer; wherein the epitaxial silicon layer extends beneath the dielectric spacers on the sidewalls of the window.

The HBT may further comprise a further dielectric layer (120) over the epitaxial silicon layer and forming an upper part of the sidewalls of the window, and separated from an upper part of the dielectric spacers by a further oxide layer (130).

According to one or more embodiments the epitaxial silicon layer extends upwardly to fill a gap, below the further oxide layer, between the dielectric spacer and the further dielectric layer.

According to one or more embodiments the layer stack comprising at least the p-doped SiGe layer further comprises a silicon layer over the SiGe layer, wherein the silicon layer over the SiGe layer is p-doped for providing an electrical connection between the base and the epitaxial silicon layer.

According to one or more embodiments a doping level of the silicon layer over the SiGe layer is uniform and in a range of 1E19 to 1E21 cm-3. According to one or more embodiments a doping level of the epitaxial silicon layer is uniform and in a range of 1E19-1 E21 cm-3. Such a doping level may contribute to a low resistance path from the intrinsic base of the HBT. According to one or more embodiments the device is free from any voids between the oxide layer and the epitaxial silicon layer. Avoidance of voids between the oxide layer and the epitaxial silicon layer may assist in reducing the resistance of the electrical path from the intrinsic base of the HBT.

According to one or more embodiments the polycrystalline silicon layer extends laterally further from the window than does the further dielectric layer. According to one or more embodiments at least one of the dielectric layer and the further dielectric layer comprise a silicon nitride material.

### Brief description of Drawings

Embodiments will be described, by way of example only, with reference to the drawings, in which
FIG. 1a. and FIG. 1b show schematic cross-section through a part-processed SiGe HBT device, according to conventional methods;
FIG. 2 shows a part-processed SiGe HBT according to one or more embodiments of the present disclosure;
FIG.s 3-13 show a part-processed SiGe HBT at various stages of manufacture, according to one or more embodiments;
FIG. 14 shows a part-processed SiGe HBT according to one or more other embodiments;
FIG. 15 shows a part-processed SiGe HBT according to one or more yet other embodiments,
FIG. 16 shows the part-processed SiGe HBT shown in FIG. 15, at a subsequent stage of manufacture; and
FIG. 17 shows a flow-chart of methods according to one or more embodiments.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments

### Detailed description of embodiments

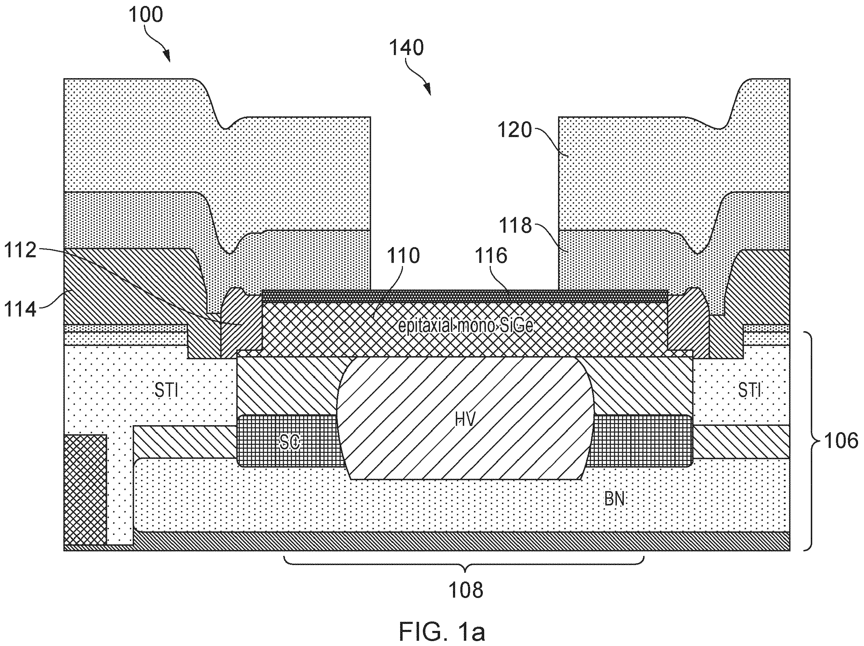

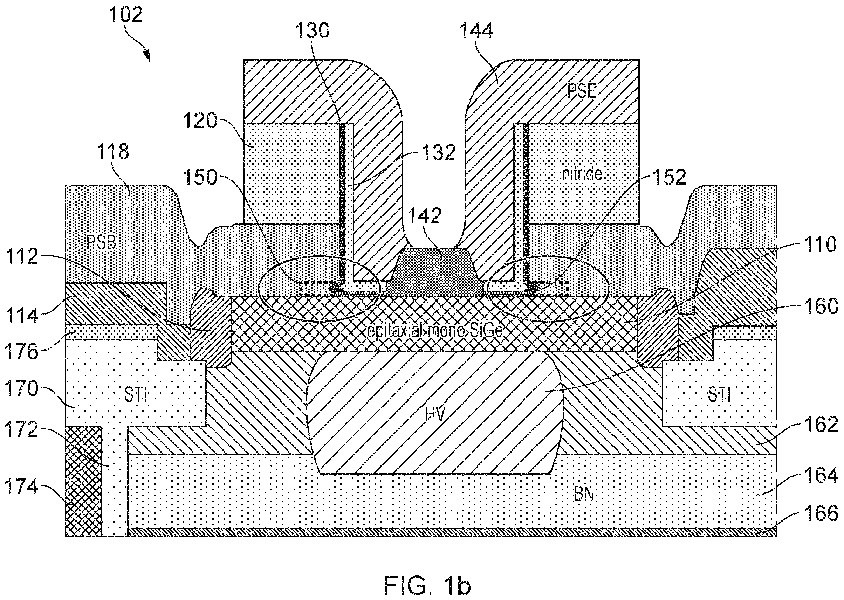

FIG. 1a shows schematic cross-section through a part-processed SiGe HBT device, and FIG. 1b shows a schematic cross-section through the same device at a later stage of the processing, according to conventional methods.

Layers and regions of the part-processed device 100 which are of relevance to the present disclosure will be described with reference to FIG 1a. Part-processed device 100 comprises a substrate 106 in which various regions of the device have been defined, as will be described in more detail with respect to FIG. 1b. Over the substrate is a layer stack 110, 112, 114 which includes Silicon-Germanium (SiGe). Across at least an active region 108 of the device, the layer stack is directly in contact with silicon from the substrate; as shown at 110, adjacent the active region 108 the layer stack comprises a transition region 112, and adjacent to the transition region the layer stack comprises a further region 114, which is not in direct contact with silicon; there is a dielectric and/or oxide layer therebetween. The layer stack 110 (and 112 and 114) may comprise a single layer of SiGe, or may, as will be familiar to the skilled person, comprise a stack of individual layers such as a layer of SiGe sandwiched between layers of silicon above and below it. At least the SiGe layer of the layer stack is heavily doped p-type (typically with boron) and forms the "p-type" base region of the npn HBT. The active region 110 of the layer stack containing SiGe is epitaxially grown on the underlying silicon and is thus monocrystalline. The transition region 112 may be partially monocrystalline and partially polycrystalline; the further region 114 is over a dielectric material, as will be explained in more detail hereinbelow, and in general may be polycrystalline. In the active region of the device, the layer stack containing SiGe is protected, during some stages of the processing of the device, by a protective layer 116. The protective layer is typically formed from an oxide such as a TEOS oxide and has the effect of protecting the underlying SiGe layer when etching the emitter window 140 of the HBT, and thus may conveniently termed as an "emitter protect oxide" or "EP oxide" for short. Over the layer stack containing SiGe, is a layer of silicon 118 which may be referred to as a polysilicon base (or PSB). At least in the region where this layer overlays the EP TEOS, it does not grow epitaxially, but is formed of polycrystalline silicon, and doped p-type (typically, with boron) sufficiently highly, such as to a level in a range 1E19 - 1E21 cm⁻³ (where 1E20= 1×10²⁰) to provide a low resistance electrical path between the base of the HBT (which is in the layer stack containing SiGe), and one or more electrical contact pads in the finished device for electrically connecting the base region between the base of the HBT and other devices in an integrated circuit. According to the present disclosure, the term "low resistance" may refer to a value which is < 100Ohm, or <1Ohm. In some devices the layer stack comprising SiGe includes a respective silicon layer over and under a SiGe layer; in such devices typically the silicon overlayer (as grown) is relatively low doped - or even not intentionally doped. In such devices, good - that is to say, in this context, low-resistivity - electrical contact to the SiGe (intrinsic) base region of the device may be enabled by diffusing boron from the PSB layer 118 into the silicon over layer to dope it sufficiently to provide such low resistivity.

Over the polysilicon base 118 is a dielectric layer 120. The dielectric layer 120 may typically comprise a nitride such as silicon nitride. As can be seen in FIG. 1a, a window 140, which is typically referred to as the emitter window, has been opened over the active region 108 of the device, through the dielectric layer 120 and the PSB layer 118, to expose the protective layer 116 over the layer stack containing SiGe. Although not shown in FIG.1a, the exposed part of the protective layer 116 may be locally thinned during the opening of the emitter window. Thereafter, the protective layer 116 is at least partially removed by etching to expose the layer stack containing SiGe. Removal of the protective layer 116 results in the PSB layer 118 being undercut resulting in a void cavity between the PSB layer 118 and the layer stack containing SiGe. A subsequent "hydrogen anneal" step is therefore carried out, comprising a thermal treatment in a hydrogen (H2) environment, which results in silicon from the PSB layer migrating into the void to fill, or "seal" it. This is illustrated in FIG. 1b by the rectangle 150. However, this sealing process is potentially nonideal, for any of a variety of reasons. Firstly, there is a potential for small voids to remain, close to the emitter window. Subsequent to later process steps in which "spacer material" is deposited on the perimeter of the emitter window, any such residual voids may increase the effective width of the spacer layer, which may be undesirable. Secondly, the doping of the PSB layer 118 in the reconstituted regions will generally be different to that in the rest of the layer. In particular, boron is typically used to dope the PSB layer, and boron will generally diffuse differently from the silicon during "sealing" of the voids, resulting in lower doping in and around the vicinity of the original voids. This may result in a higher electrical resistivity of the layer. Furthermore, with a lower density of boron in this region, there is less boron available to diffuse into any silicon over-layer forming part of the layer stack containing SiGe. An additional annealing step may be introduced in order to diffuse boron more uniformly into the link, but this may still not resolve the resistivity problem. Thirdly, the PSB region is still polysilicon, which will have higher resistivity and less dopant activation than a single crystal film.

Subsequent to the hydrogen anneal stage, spacer material is deposited on the sidewalls and bottom of the emitter window. The spacer material is generally dielectric and may comprise a single layer of nitride. Alternatively, and without limitation, it may comprise a thin layer of oxide 130 followed by another layer of nitride, 132, as shown in FIG.1b. The skilled person will appreciate that other combinations of layers may be used to provide the spacers, such as an "ONO" stack. As can be seen in FIG. 1b, the spacer material fills any remaining residual small voids 152 in the PSB layer subsequent to the hydrogen anneal stage. Typically these spacers, also referred to as inside spacers, are constructed by deposition of an ONO plus polysilicon stack (ONO+Poly-Si). The polysilicon is etched into a spacer stopping on the top oxide of the ONO stack. Next the nitride is etched during which step the polysilicon is also removed. Later the top oxide of the ONO is removed by doing a short HF dip before depositing the emitter silicon. Therefore, all that is left of the ONO+poly-Si is the bottom oxide (130) and the nitride (132).

Next, an opening is made through the spacer material in at least part of the bottom of the emitter window, to enable subsequent deposition of a silicon layer forming emitter region 142, which thus is in direct contact with the layer stack containing SiGe. The emitter region 142 is typically heavily doped. Concurrent with the deposition of 142 (which is usually monocrystalline), a silicon layer 144 (which is usually polycrystalline) is deposited over the device, and patterned as shown at FIG. 1b so as to provide a low resistance electrical path between emitter region 142 and one or more electrical contact pads provided for contacting the emitter, or between the emitter region of the device and other devices in the integrated circuit.

Various other regions which form part of the HBT, but are of less or no significance for the present disclosure, are also shown in FIG.1b. These include a doped collector region ("HV") 160 beneath the layer stack containing SiGe; the doped collector region 160 may be formed, typically by ion implantation, in a region 162 of the substrate which has been epitaxially grown and forms an n-well. Below the n-well 162 may be a buried layer ("BN") 164 which may be doped n-type and forms a buried n-well. The buried n-well 164 may be over a substrate 166 which is typically doped p-type. Around the perimeter of the device may be oxide regions 170 providing shallow trench isolation ("STI") and, or alternatively, oxide 172 and polysilicon 174 regions forming deep trench isolation ("DTI"). The layer stack containing SiGe may be separated from either the STI or DTI regions by a nitride layer 176.

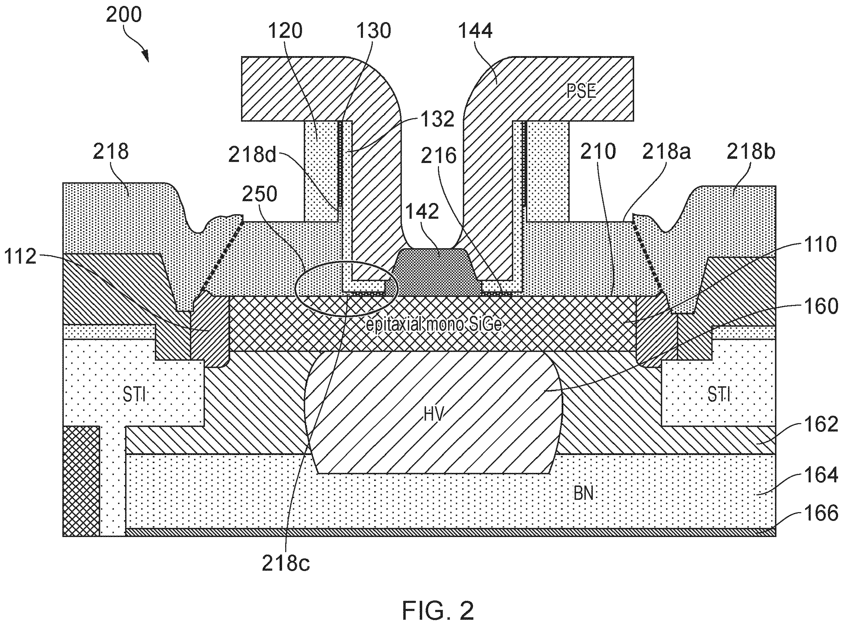

Turning now to FIG. 2, this shows a part-processed SiGe HBT 200 according to one or more embodiments of the present disclosure. This part-processed device is generally similar to that shown in FIG. 1b, and corresponding regions are depicted with corresponding references. However, in this part-processed device, the original polysilicon base layer has been removed during the device processing (and is thus not shown) and replaced with a replacement silicon layer 218. The original polysilicon base layer may therefore be described as a sacrificial layer 318 (since it is removed during device processing). The replacement layer 218 may be at least partially epitaxially grown and thus be monocrystalline silicon, as will be explained in more detail hereinbelow. In particular, there is no protective oxide between an active area of the layer stack containing SiGe and the replacement layer, and the replacement layer is formed directly on the layer stack including SiGe. Wherever the top layer of the layer stack including SiGe, which is typically a silicon layer, is monocrystalline - and that includes across the active part of the device, the replacement layer is able to grow epitaxially, thereby forming a monocrystalline layer 218a. Elsewhere, such as in region 218b, the replacement layer is polycrystalline, since it is not grown on monocrystalline silicon.

As will be explained in more detail hereinbelow, according to one or more embodiments of the present disclosure, the oxide layer 130, within the spacer material comprising oxide layer 130 and nitride layer 132, has been partially removed by etching. In particular, according to the embodiment illustrated in FIG. 2 and as shown in the highlighted area 250, the oxide under the outermost corner of the bottom of the emitter window and underneath nitride layer in the corner has been removed by the typically wet etch that is used to remove remaining parts of layer 216. The replacement layer 218 fills the gap produced thereby, resulting in "lugs" or tabs 218c of epitaxial silicon under the corner of the spacer. Moreover, the oxide adjacent the bottom of the nitride layer 120 has also been removed by the etchant used to remove the sacrificial layer, and the replacement layer fills the gaps produce thereby, resulting in up-stand regions 218d, as shown.

The replacement layer 218 may typically be heavily doped p-type with boron. It will be appreciated that, particularly compared with the PSB layer 118 described above, the doping in the replacement layer 218 may be uniform. The doping level may be relatively high, such as to a level in a range 1 E19 -2E21 cm⁻³, or 1 E20-2E21. During subsequent thermal processing, this dopant may diffuse into an overlay silicon layer forming part of the layer stack including SiGe to provide a low resistivity in the silicon over layer, and thereby provide a low resistance ohmic contact path to the SiGe intrinsic base.

An outline process flow by which a replacement layer 218 may be provided in an HBT device will now be described with respect to FIG.s 3 to 13.

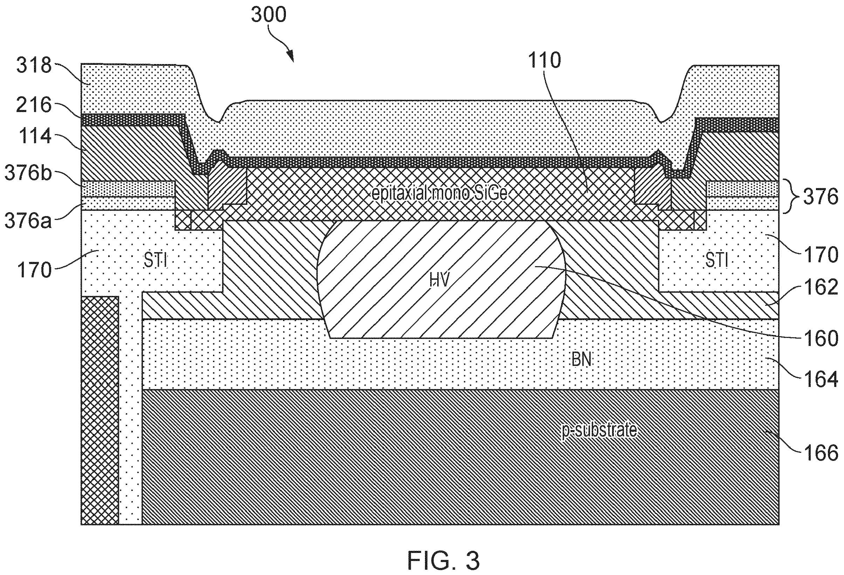

FIG. 3 shows a schematic cross-section through a part-processed SiGe HBT device 300. In a substrate 166 which may be doped p-type is provided a buried n-well, BN, 164, over which a n-type n-well 162 is formed. Oxide forming a shallow trench isolation, STI, 170 is grown or deposited on either side of an active region of the device. At least the central part of an active region of the device is then heavily doped n-type by implantation, to form the collector region 160 of the final HBT device. The skilled person will be aware that the collector region may also be described as the "intrinsic" collector.

A protective layer 376 is grown over the device. The protective layer 176 may be formed of multiple layers such as, as shown, a first layer of nitride 376a, and a second layer of polysilicon 376b. A window is etched through this layer over at least an active area of the device. The etching of the window may partially etch the STI oxide 170 as a last process step before defining the SiGe HBT device, as shown.

A layer stack 110 containing SiGe is then grown over the device. In the window region the layer stack comprises monocrystalline SiGe; elsewhere, where the layer stack is grown over the protective layer 176, it comprises polycrystalline SiGe. A protective oxide layer 216 is then grown or deposited over the layer stack containing SiGe, and a sacrificial polysilicon layer 318 is deposited over the protective oxide layer 216. Part of the sacrificial layer will be removed during conventional process steps such as opening an emitter window (will be described in more detail hereinbelow). However the layer may be termed "sacrificial" since, according to embodiments of the present disclosure, the part of the layer which would otherwise be used to provide electrical contact to the intrinsic base region of the final device is removed or "sacrificed", and replaced by physically different material.

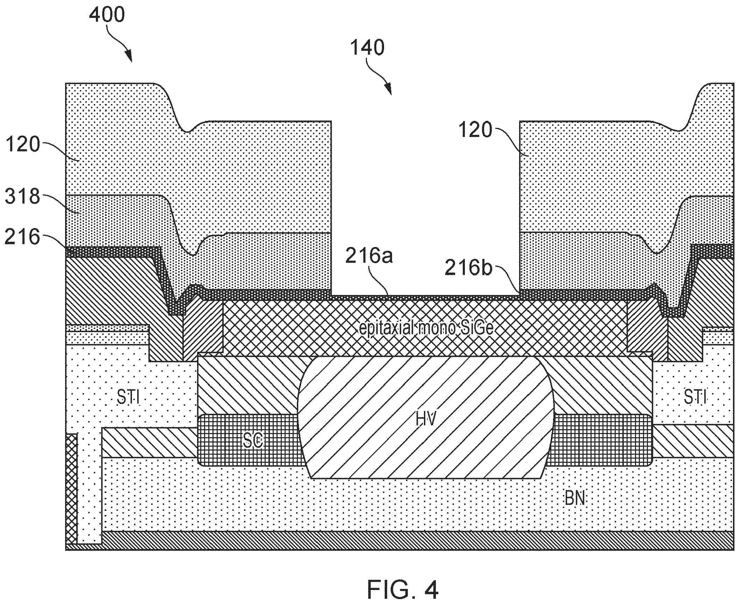

FIG. 4 shows a schematic cross-section through a part-processed SiGe HBT device 400 at a later stage of processing. A dielectric layer 120, which may typically be a nitride layer and thus may be referred to as a base nitride, is deposited over the sacrificial polysilicon layer 318. A window 140 is then etched through the base nitride 120 and polysilicon layer 318, in a photolithographically defined region, and which may be described as an emitter window. As can be seen in FIG.4, the protective oxide layer 216 may be partially etched during the etching of the emitter window so as to result in an oxide layer 216a which is thus thinner than the oxide layer 216b elsewhere over the device.

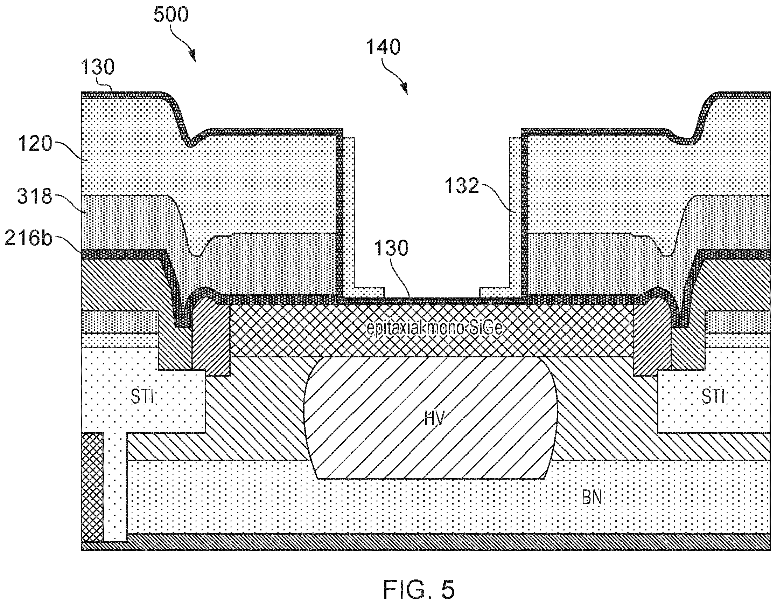

FIG. 5 shows a schematic cross-section through a part-processed SiGe HBT device 500 at a yet later stage of processing. Over the base nitride layer 120 and including in the window 140 is deposited a thin oxide layer 130 the layer may typically have a thickness of the order of 4 nm, or be within a range of 2 to 30 nm. Subsequent to the position of the oxide layer, a nitride layer 132 is deposited across the device. The nitride layer 132 is subsequently etched using an anisotropic etching process, such as a reactive ion etching (RIE), or reactive ion beam etching (RIBE). The nitride layer 132 is thereby removed from most of the device, however due to the anisotropic nature of the etching, nitride 132 remains on the sidewalls of the emitter window 140. A thin sacrificial polysilicon layer may be deposited over the nitride (not shown), that is etched first during the spacer etch, but protects the nitride at the bottom of the emitter window. The poly is then removed. It may also, as shown, extend partially around the bottom corner of the sidewalls to the bottom of the emitter window 140.

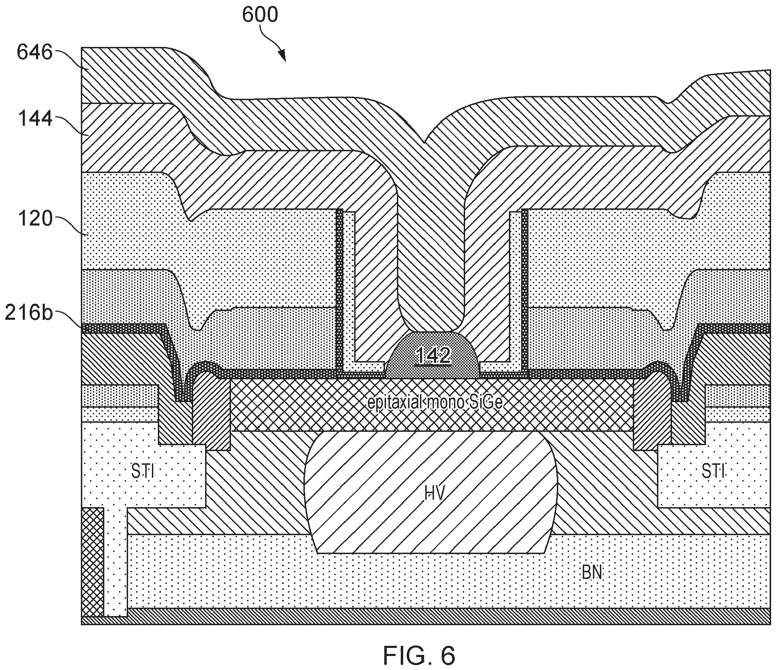

FIG. 6 shows a schematic cross-section through a part-processed SiGe HBT device 600 at a still later stage of processing. The remaining oxide layer 130 in the bottom of the emitter window has been removed by etching to expose the layer stack containing SiGe. The same oxide etch process also removes the oxide layer 130 from the remainder of the device in particular from the base nitride 120 outside the emitter window. A silicon layer is then deposited across the device including in the emitter window. Where the silicon is in direct contact with the layer stack containing SiGe, it grows as epitaxial monocrystalline silicon in the emitter region 142. This silicon region forms the eventual emitter of the HBT in the finished device. Elsewhere, the silicon forms as a polycrystalline layer 144 on the sidewalls of the emitter window and over the base nitride 120. This silicon will, in the final HBT device, provide electrical connection to the emitter region 142. The polysilicon layer 144 may therefore be described as the extrinsic emitter, or emitter contact layer, whilst the emitter region 142 may be described as the intrinsic emitter. According to embodiments of the present disclosure, a further protective oxide 646 is deposited over the polysilicon emitter contact layer 144. As will become apparent hereinunder, this further protective oxide 646 will be removed during later stages of processing.

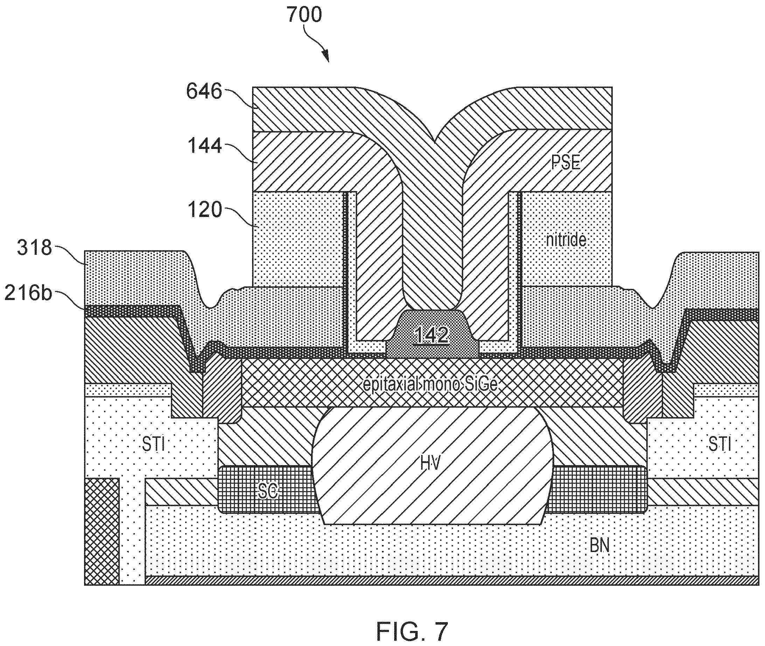

FIG. 7 shows a schematic cross-section through a part-processed SiGe HBT device 700 at a still later stage of processing. A further photolithography stage is used to pattern the further protective oxide 646 over the intrinsic emitter in the emitter window and over the emitter contact layer 144 adjacent to the window. The further protective oxide 646 elsewhere across the device is then removed by etching. The emitter contact layer 144 is also removed by etching using an etch which removes the polysilicon material but is selective against nitride material forming the base nitride 120. Subsequently, an etchant which has opposite selectivity - that is to say it can etch nitride material but is selective against silicon and in particular polysilicon material - is used to remove the base nitride 120 from regions of the device remote from the emitter window. This etchant exposes the sacrificial layer 318.

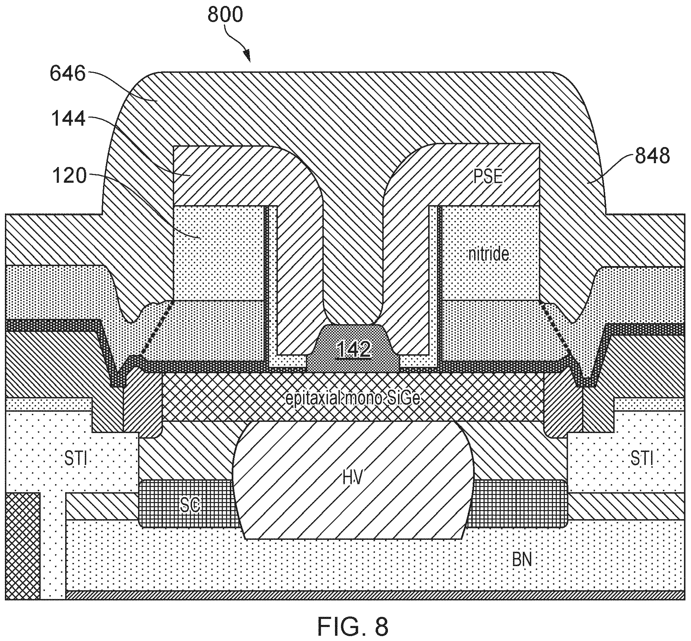

FIG. 8 shows a schematic cross-section through a part-processed SiGe HBT device 800 at a still later stage of processing. Yet further protective oxide 848 is deposited across the device. This oxide may be indistinguishable from the further protective oxide 646 across the active part of a device and in particular protecting the emitter window and intrinsic emitter. In particular, the boundary between oxide 646 and 848 is not visible in FIG. 8.

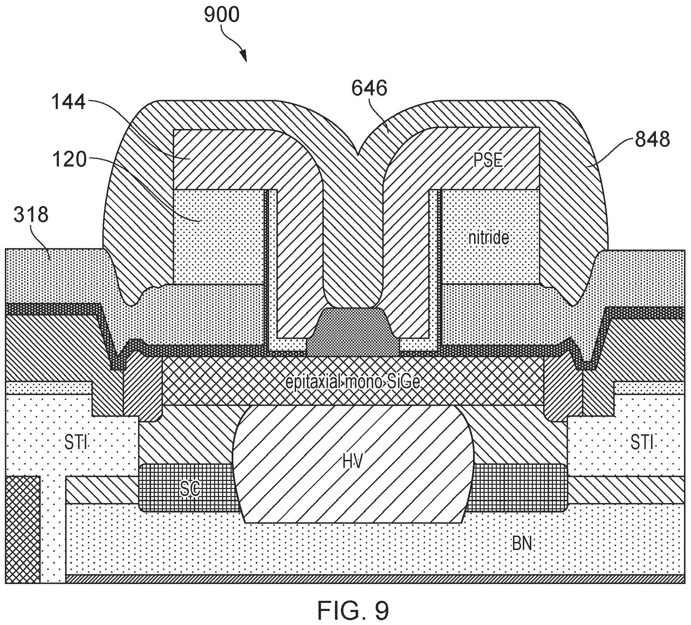

FIG. 9 shows a schematic cross-section through a part-processed SiGe HBT device 900 at a still later stage of processing. The yet further protective oxide 848 is removed remote from the active region of the device using anisotropic etching, forming oxide spacers from layer 848 and leaving part of layer 646 over the emitter layer 144. It will be appreciated that the dimensions and in particular the thickness of the remaining further protective oxide 848 is non-critical provided that the base nitride 120 and the polysilicon emitter 144 are fully encapsulated and protected. Moreover, any small consumption of the polysilicon base 318 resulting from imperfect selectivity of the etchant is not a concern, since during a subsequent stage this layer will be entirely removed.

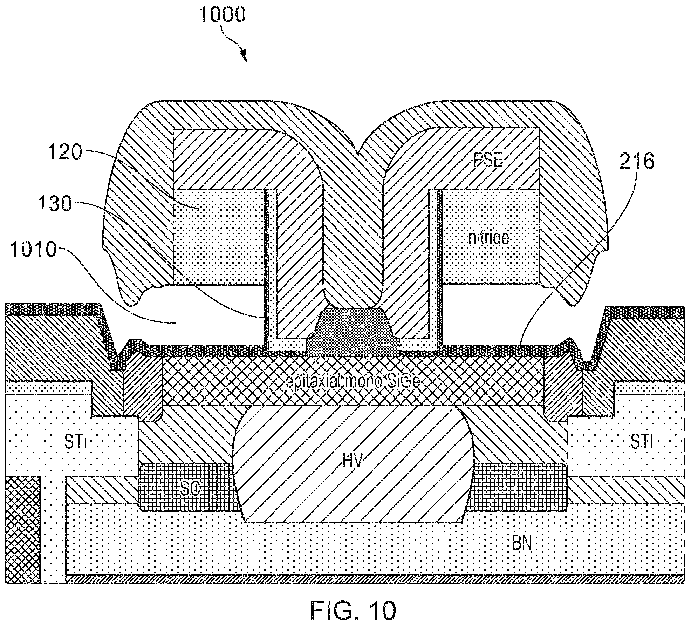

FIG. 10 shows a schematic cross-section through a part-processed SiGe HBT device 1000 at a still later stage of processing. Sacrificial layer 318 has been removed by etching to leave a cavity 1010 and exposed oxide. In particular the etching may be carried out using a dry etch having high selectivity against silicon oxide in order to remove the polysilicon material of the sacrificial layer 318, and stop at the oxide 216 underneath the sacrificial layer and the oxide 130 on the sidewalls of the emitter window. A suitable dry etch may be based on sulphur hexafluorine (SF₆)- based chemistry. It will be appreciated that in order to minimise removal (from underneath) of the base nitride 120, a high selectivity against silicon nitride in the etch chemistry may be desirable, but is not critical.

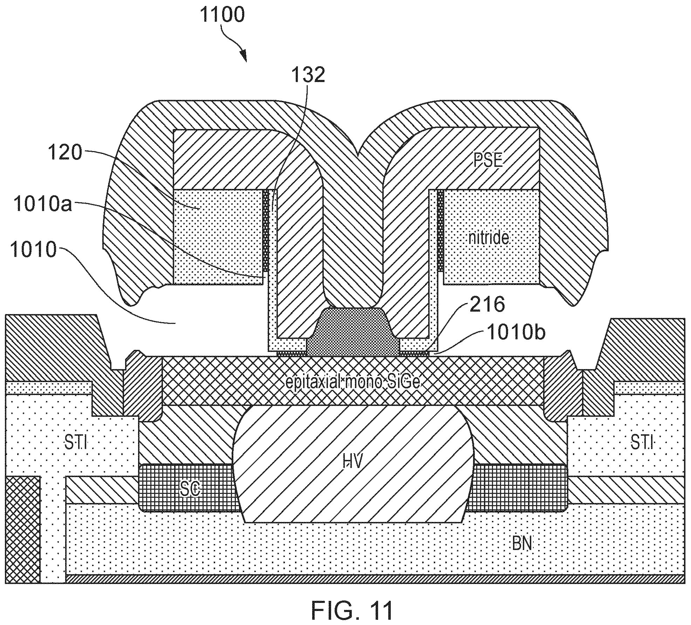

FIG. 11 shows a schematic cross-section through a part-processed SiGe HBT device 1100 at a still later stage of processing. The oxide 216 underneath the sacrificial layer and the oxide 130 of the sidewalls of the emitter window have been partly removed by etching. This may be conveniently done by means of a hydrogen fluoride (HF) dip. As can be seen in the figure, removal of the oxide on the sidewalls of the emitter window may result in the cavity extending upwardly between the emitter window nitride layer 132 and the base nitride 120, as shown at 1010a. Furthermore, removal of the exposed protective oxide layer 216b over the layer stack containing SiGe may result in the oxide under the nitride spacers in the perimeter of the emitter window being etched from the side resulting in an undercut as shown at 1010b. These two artefacts may each provide evidence, in the final HBT device, that the original polysilicon layer 318 was a sacrificial layer which has been removed and replaced by a replacement layer 218, as will be described in more detail hereinbelow with reference to FIG.s 12 and 13.

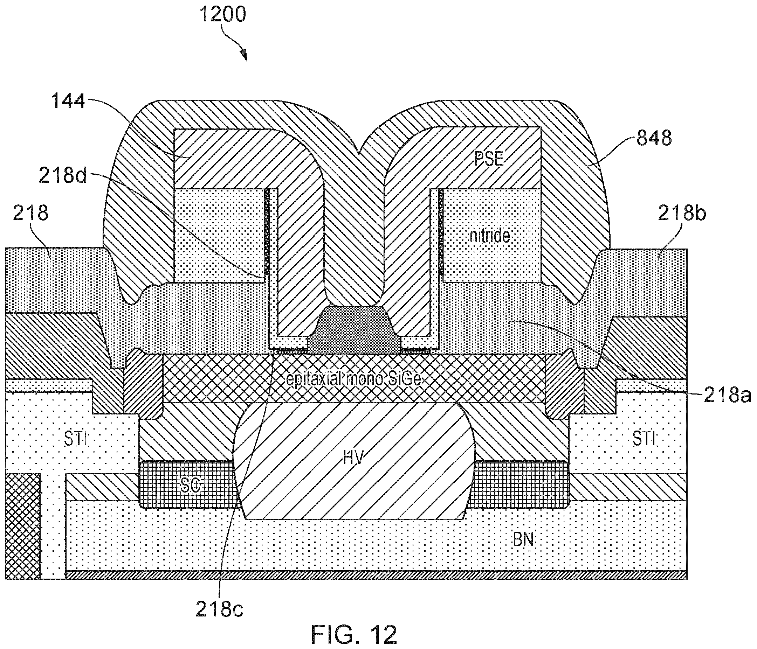

FIG. 12 shows a schematic cross-section through a part-processed SiGe HBT device 1200 at a still later stage of processing. A silicon layer 218 has been grown on the device to replace the original (and now removed) polysilicon base PSB 318. The growth of the silicon layer has been carried out by a selective growth chemistry and method such that it only grows on silicon (either monocrystalline or polycrystalline) and does not grow on exposed nitride or oxide. The growth is epitaxial and results in monocrystalline silicon on monocrystalline substrate and polycrystalline silicon on the polycrystalline substrate. In particular, where the silicon is grown directly onto the monocrystalline silicon forming the upper layer of the layer stack comprising SiGe in the active area of the device, it will be monocrystalline and this is shown in region 218a. In contrast, where the silicon is grown on the layer stack comprising SiGe outside of the active area of the device, the layer stack comprising silicon is polycrystalline and thus the grown replacement silicon layer is also polycrystalline. This is shown in region 218b.

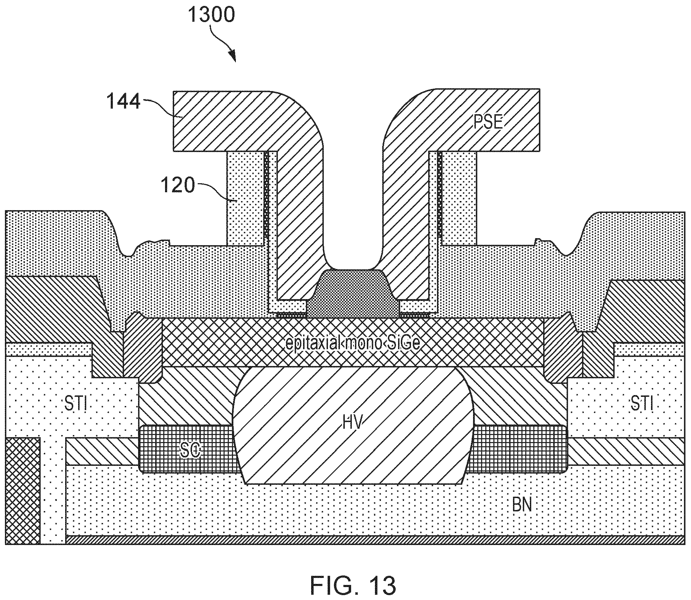

FIG. 13 shows a schematic cross-section through a part-processed SiGe HBT device 1300 at a still later stage of processing. The residual yet further protective oxide 848 protecting the sidewalls of the emitter contact layer 144 and base nitride 120 has been removed by etching together with the further protective oxide layer 646 protecting the emitter contact layer. This may typically be carried out by wet etch processing such as using highly selective HF based etchant. Furthermore, as shown, the base nitride 120 may be partially etched to reduce its lateral thickness thereby undercutting the emitter contact layer 144 for maximum exposure to silicidation.

With an, appropriately doped, replacement silicon layer 218 in place of the original sacrificial layer, the processing of the HBT device may continue using conventional processing steps.

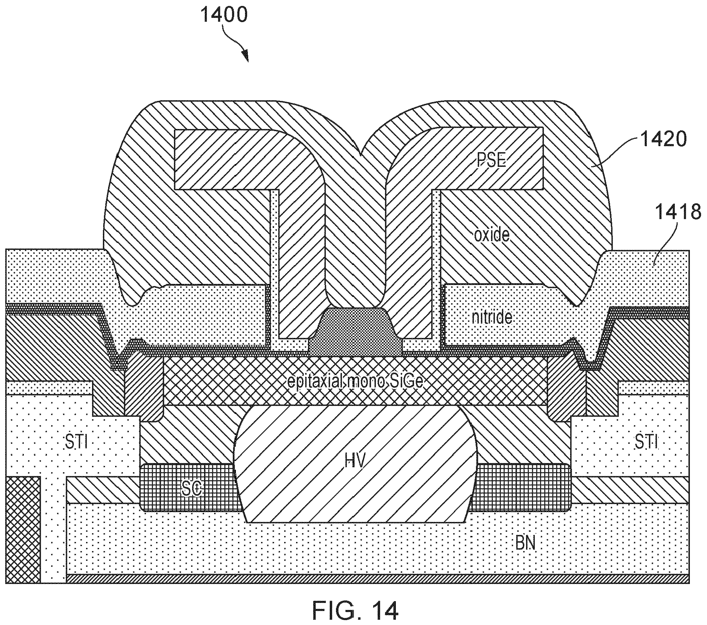

FIG. 14 shows a schematic cross-section through a part-processed SiGe HBT device 1400 according to one or more other embodiments of the present disclosure. In particular, in place of a sacrificial polysilicon layer 318, the sacrificial layer comprises a stack including a nitride material 1418, and an oxide layer 1420. The oxide layer 1420 may be for instance a TEOS layer. The polysilicon dry etch process may then be replaced by a wet nitride etch using, for example hot phosphoric acid -based chemistry (H₃PO₄) having a high selectivity to oxide.

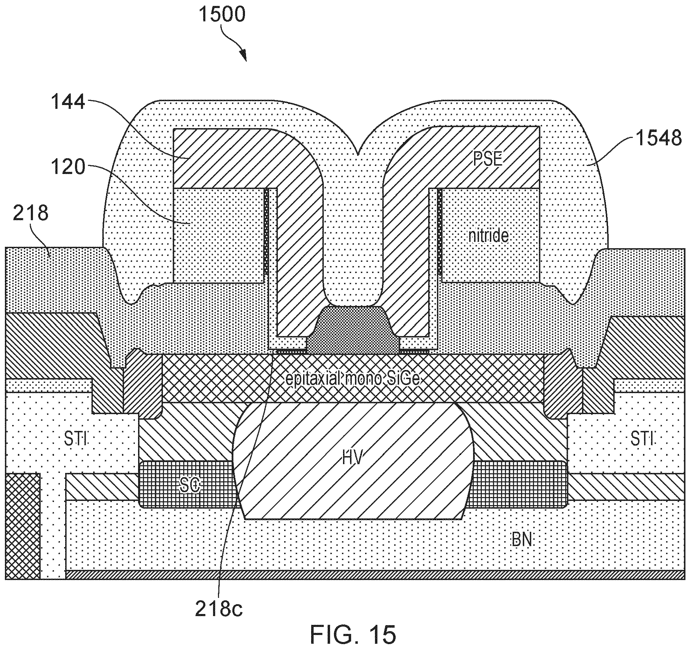

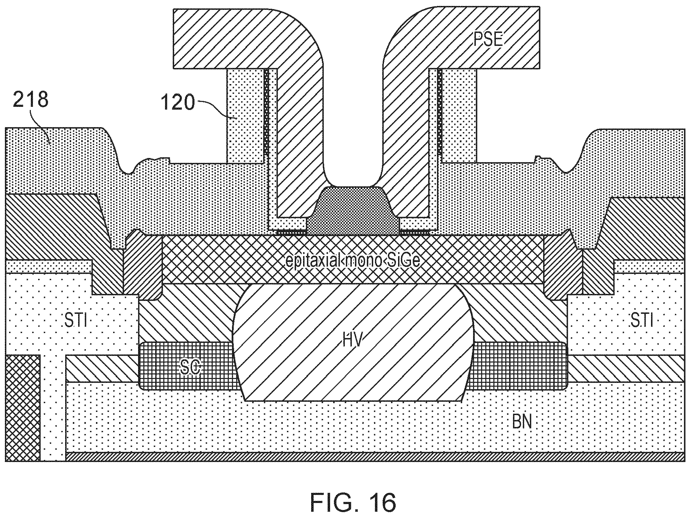

According to one or more yet other embodiments, the silicon oxide layer used to protect the emitter and outside spacers may be replaced by a nitride layer. In other words, the "hard mask" oxide may be replaced by a "soft mask" nitride such as PECVD nitride. This is illustrated in FIG.s 15 and 16. FIG. 15 shows the "soft mask" PECVD nitride protecting the base nitride layer 120 and the emitter contact layer 144. During removal of the soft mask subsequent to the replacement of the sacrificial polysilicon layer 318 by the replacement layer 218, this PECVD nitride - which is less dense than LPCVD nitride - will etch at a higher rate than the nitride 120. The etch time may be adjusted so as to allow for an appropriate level of lateral undercut, as shown in FIG. 16. This may enable the silicide deposited on the epitaxial base (ie the monocrystalline replacement silicon layer 218a) during subsequent conventional processing to brought into close contact to the intrinsic base layer of the device.

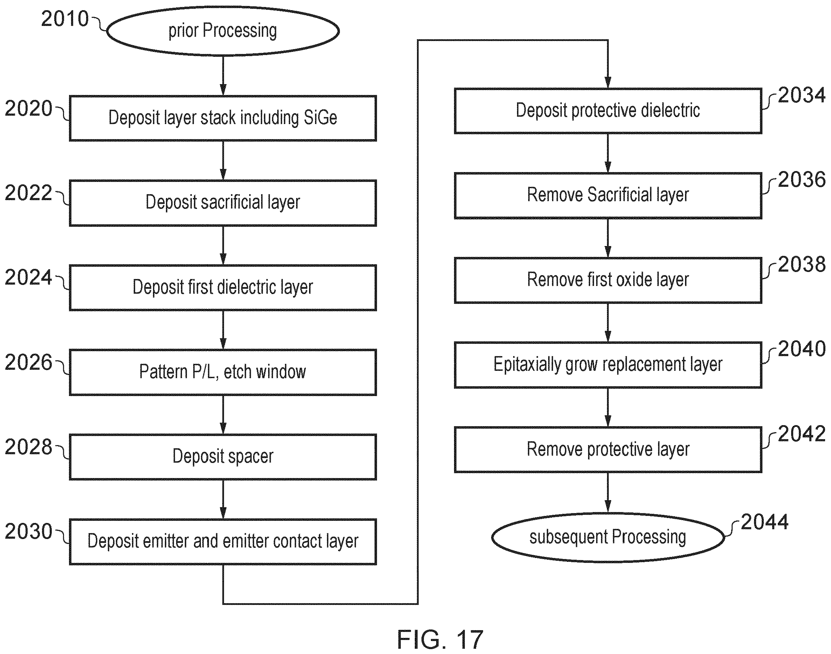

FIG. 17 shows a flow-chart of methods according to one or more embodiments of the present disclosure. As shown in the figure, the process includes the steps of:
2020 - Deposit layer stack including SiGe;
2022 - Deposit sacrificial layer;
2024 - Deposit first dielectric layer;
2026 -Pattern Photolithogaphy, etch window;
2028 - Deposit spacer;
2030 - Deposit emitter and emitter contact layer;
2034 - Deposit protective dielectric;
2036 - Remove sacrificial layer;
2038 - Remove the first oxide ;
2040 - Epitaxially grown replacement layer;
2042 - Remove protective layer;
2044 - Subsequent processing.

It will be appreciated that fabrication of the final HBT includes many additional process steps. However the above-described flowchart is limited to those which are necessary for the present disclosure.

From reading the present disclosure, other variations and modifications will be apparent to the skilled person. Such variations and modifications may involve equivalent and other features which are already known in the art of semiconductor device fabrication, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, and reference signs in the claims shall not be construed as limiting the scope of the claims. Furthermore, the word "may" is used in a permissive sense (i.e., meaning having the potential to), rather than the mandatory sense (i.e., meaning must). Similarly, the words "include," "including," and "includes" mean including, but not limited to.

### LIST OF REFERENCE SIGNS

- 100: part-processed device
- 106: substrate
- 108: active region
- 110: layer stack comprising SiGe
- 112: layer stack transition region
- 114: layer stack further region
- 116: protective layer
- 118: polysilicon base PSB
- 120: dielectric layer/ base nitride
- 130: thin layer of oxide
- 132: nitride layer
- 140: emitter window
- 142: emitter region
- 144: further silicon layer/ emitter contact layer
- 150: highlighted region
- 152: residual small voids
- 160: doped collector region
- 162: n-well
- 164: buried n-well
- 166: substrate
- 170: STI oxide region
- 172: DTI oxide
- 174: DTI polysilicon
- 176: nitride layer
- 200: part-processed SiGe HBT
- 210: upper surface of layer stack comprising SiGe
- 216: protective oxide layer
- 216a: oxide layer in emitter window
- 216b: oxide layer elsewhere
- 218: replacement silicon layer
- 218a: monocrystalline replacement silicon layer
- 218b: polycrystalline replacement silicon layer
- 218c: epitaxial silicon tabs
- 218d: epitaxial silicon up-stand regions
- 250: highlighted area
- 300: part-processed SiGe HBT
- 318: sacrificial polysilicon layer
- 376: protective layer
- 376a: nitride
- 376b: polysilicon
- 400, 500, 600: part-processed SiGe HBT
- 646: further protective oxide layer
- 700, 800: part-processed SiGe HBT
- 848: yet further protective oxide
- 900, 1000: part-processed SiGe HBT
- 1010: cavity
- 1010a: cavity extension
- 1010b: cavity extension
- 1100, 1200: part-processed SiGe HBT
- 1300, 1400: part-processed SiGe HBT
- 1418: nitride
- 1420: oxide layer
- 1500: part-processed SiGe HBT
- 1548: PE CVD nitride
- 1600: part-processed SiGe HBT
- 2010 - 2044: manufacturing steps

## Claims

1. A SiGe Heterojunction Bipolar Transistor, HBT, (200) comprising an emitter, a base and a collector, wherein:
the collector comprises an n-doped implanted region (160);
the base comprises a p-doped SiGe layer, within a layer stack (110) comprising at least the p-doped SiGe layer and having an upper surface (210), the layer stack being over and in direct contact with the collector;
the emitter comprises an n-doped monocrystalline silicon emitter (142) over and in direct contact with a first area of the upper surface of the layer stack;
wherein the HBT further comprises:
an epitaxial silicon layer (218) over and in direct contact with a second area of the upper surface of the layer stack, and for providing an electrical connection to the base;
a polycrystalline silicon [emitter contact] layer (144) for providing an electrical connection to the emitter;
an oxide layer (216) over and in direct contact with a third area of the upper surface of the layer stack between the first area and the second area, wherein the oxide layer and the n-doped monocrystalline silicon emitter are within a window in the epitaxial silicon layer, wherein the window has sidewalls;
dielectric spacers (132) on the sidewalls of the window and over the oxide layer, and providing electrical isolation between the epitaxial silicon layer and the polycrystalline silicon layer; and
wherein the epitaxial silicon layer extends beneath the dielectric spacers on the sidewalls of the window.

2. The SiGe HBT according to claim 1, further comprising
a further dielectric layer (120) over the epitaxial silicon layer and forming an upper part of the sidewalls of the window, and separated from an upper part of the dielectric spacers by a further oxide layer (130).

3. The SiGe HBT according to claim 2, wherein
the epitaxial silicon layer extends upwardly to fill a gap, below the further oxide layer, between the dielectric spacer and the further dielectric layer.

4. The SiGe HBT according to any preceding claim, wherein
the layer stack layer stack comprising at least the p-doped SiGe layer further comprises a silicon layer over the SiGe layer, wherein the silicon layer over the SiGe layer is p-doped for providing an electrical connection between the base and the epitaxial silicon layer.

5. The SiGe HBT according to claim 4, wherein
a doping level of the silicon layer over the SiGe layer is uniform and in a range 1E19 to 1E21 cm-3.

6. The SiGe HBT according to any preceding claim, wherein
a doping level of the epitaxial silicon layer is uniform and in a range of 1E19-1E21 cm-3.

7. The SiGe HBT according to any preceding claim, wherein
the HBT is free from any voids between the oxide layer and the epitaxial silicon layer.

8. The SiGe HBT according to any preceding claim, wherein
the polycrystalline silicon layer extends laterally further from the window than does the further dielectric layer.

9. The SiGe HBT according to any preceding claim, wherein
at least one of the dielectric layer and the further dielectric layer comprise a silicon nitride material.

10. A method of manufacturing a SiGe Heterojunction junction transistor device, the method comprising a sequence of steps including:
prior (2010) processing steps;
depositing (2020) a layer stack comprising SiGe (110), and a first oxide layer (216), on at least a device region;
depositing (2022) at least a sacrificial layer (318) over the device region;
depositing (2024) a first dielectric layer (120) over the sacrificial layer patterning (2026) a photoresist layer and etching (2026) a window (140) in the first dielectric layer (120) and the sacrificial layer (318) through an opening in the photoresist layer;
depositing (2028) a dielectric spacer comprising an oxide layer (130) and a nitride layer (132) on sidewalls of the window and on a part of a bottom of the window;
depositing (2030) a monocrystalline silicon emitter layer (142) in the bottom of the window and
a polycrystalline silicon emitter contact layer (144) over the dielectric spacer and the silicon emitter layer;
depositing (2034) a protective dielectric layer (646, 848) over the silicon emitter layer, thereby filling the window, and surrounding the silicon emitter contact layer;
removing (2036) the sacrificial layer;
removing (2038) the first oxide layer (216);
epitaxially growing (2040) a silicon layer;
removing (2042) the protective dielectric layer; and
subsequent (2044) processing steps.

11. The method of claim 10 wherein the sacrificial layer is a polysilicon layer (318).

12. The method of claim 10 or 11, wherein the dielectric layer over the sacrificial layer comprises a nitride layer.

13. The method of claim 11, wherein the sacrificial layer is a nitride layer (1418), and the first dielectric layer over the sacrificial layer is an oxide layer (1420).

14. The method of any of claims 10 to 13, wherein the protective dielectric layer is an oxide layer (646, 848).

15. The method of any of claims 10 to 13, wherein the protective dielectric layer is a nitride layer (1548).
